# EUROPEAN PATENT APPLICATION

(11) **EP 4 667 894 A1**
(43) Date of publication of application: **24.12.2025**
(21) Application number: 24756293.7
(22) Date of filing: 08.02.2024
(51) Int. Cl.: G01M 17/007, G01M 17/06

(54) **CHASSIS DYNAMOMETER, VEHICLE TEST BENCH, AND METHOD FOR SIMULATING ACTUAL ROAD DRIVING OF VEHICLE**

(30) Priority: 16.02.2023 CN 202310126042
(71) Applicant: BEP (China) Testing Equipment Co., Ltd., Wuxi, Jiangsu 214001 (CN)
(72) Inventor: ZHANG, Mande, Wuxi, Jiangsu 214001 (CN); WAN, Hua, Wuxi, Jiangsu 214001 (CN); CHEN, Ronggui, Wuxi, Jiangsu 214001 (CN); XU, Chao, Wuxi, Jiangsu 214001 (CN)
(74) Representative: Moser Götze & Partner Patentanwälte mbB
(86) International application number: PCT/CN2024/076919
(87) International publication number: WO 2024/169921

(57) **Abstract**

The present application discloses a chassis dynamometer for testing a vehicle, comprising: a front wheel test assembly; a rear wheel test assembly; a control device; the front wheel test assembly comprises: a front base frame; two universal slides, which are slidably arranged on the front base frame along a second direction perpendicular to a first direction and a vertical direction, and are configured to be able to rotate around a vertical direction; a front wheel hub bracket rotatably arranged on the universal slides; a slewing power-assisted drive device, which is fixed on the front wheel hub bracket and is configured to drive the front wheel hub bracket to rotate around a vertical direction. The present application also discloses a vehicle test bench including the chassis dynamometer and a method for simulating actual road driving of a vehicle.

## Description

### TECHNICAL FIELD

The present application relates to vehicle testing equipment, in particular to a chassis dynamometer, a vehicle test bench with the chassis dynamometer, and a method for simulating actual road driving of a vehicle.

### BACKGROUND

The development cycle of advanced driver assistance systems (ADAS), active safety systems and autonomous driving (AD) technologies requires extensive calibration, testing and validation before such systems can be promoted to production lines and real-world applications. It is in the interest of OEMs and automotive suppliers to accelerate these development cycles and extend active testing time to ensure compliance with expected performance levels and test fault tolerance limits. Traditional approaches to these test tasks are usually completed by running vehicles with prototype driving functions in closed proving grounds and limited performance evaluations on public roads. Therefore, the number and coverage of these tests are quite limited due to the costs associated with these test methods. Alternatively, simulation-based development and testing of ADAS technologies is often preferred, with the main advantage of being able to easily vary a wide range of input parameters and scenarios. Among all possible scenarios, only a small subset poses a challenge to the ADAS functionality, potentially leading to faulty behavior. Therefore, a subset of scenarios needs to be appropriately selected from all possible scenario variations, which will result in sufficient scenario coverage. However, simulation-based analysis alone is often insufficient or impossible to fully validate such systems in every possible driving scenario before they are deployed.

To address this problem, technicians have developed new test modes that combine virtual and real tests in various ways, and the physical models of all relevant subsystems and active safety control systems can be realistically simulated. In the vehicle field, real-time hardware-in-the-loop (HIL) simulation is quite common research and is used in engine development, electronic control unit (ECU) development, and the development and testing of electric vehicle components. The specific implementation of HIL simulation technology on the whole vehicle is named vehicle-in-the-loop (VIL) simulation. This concept places a complete real-world vehicle on a rolling chassis dynamometer and realistically simulates the environment, sensors and/or the vehicle itself. Real hardware components, such as ECUs or sensors and their respective control logic, can be tested in a real-time simulation environment in a coupled manner. HIL simulation has been widely used in the development of active safety systems, such as ABS and ESC systems. In these implementations, the vehicle dynamics simulation outputs relevant necessary signals (such as wheel speed, acceleration, rotation rate, steering angle, etc.) to the ECU to test the reaction of the ECU and/or its programmed software functions. In such a setup, vehicle dynamics and road conditions are usually simulated, and the physical ECU is integrated into the simulation to evaluate the ECU's reaction to virtual driving scenarios. A further extension of the hybrid test concept is the vehicle-in-the-loop (VIL) simulation concept. Here, a real vehicle on a test bench is combined with a simulation framework. The idea behind this setup is that the vehicle motion in the simulation is directly linked to the vehicle driving on the test bench. In such a setup, the test bench needs to be able to set specific road load conditions provided by the simulation environment. If ADAS functions need to be integrated and evaluated in such a framework, conventional test benches reach their limits and cannot simulate steering behavior. In other words, it is not possible to test the steering of a vehicle in VIL simulation using conventional linear rolling vehicle test benches.

In summary, it is desired to develop a chassis dynamometer and a vehicle test bench including the chassis dynamometer to simulate a scenario in which a vehicle turns while driving and obtain corresponding experimental results.

### SUMMARY OF THE INVENTION

In order to solve the problems in the prior art, the present application proposes a chassis dynamometer and a corresponding vehicle testing method to develop and test ADAS, active safety systems and AD technologies. In a traditional linear rolling chassis dynamometer, physical steering of the vehicle is impossible. In contrast, the chassis dynamometer according to the present application allows independent steering of the front wheels of the vehicle by rotating the front wheel hub assembly around their respective vertical axes. This allows the driver or the autonomous driving controller to make longitudinal and lateral inputs to the vehicle, namely acceleration, braking and steering inputs.

The present application also proposes a vehicle test bench including the chassis dynamometer and a corresponding vehicle testing method to perform dynamic and visual simulation of driving scenarios for manually driven or autonomous driving vehicles, and to perform real rolling condition tests on the vehicle test bench. Using this method, various driving conditions can be simulated and reproduced. This allows the corresponding ADAS, active safety systems and AD technologies to be adjusted to meet the expected performance targets.

The present application proposes a chassis dynamometer for testing a vehicle, the chassis dynamometer comprising : a front wheel test assembly; a rear wheel test assembly, which is separated from the front wheel test assembly by a distance in a first direction and is configured to be able to adjust the distance between the front wheel test assembly and the rear wheel test assembly to adapt to different vehicle wheelbases; a control device, which is electrically connected to the front wheel test assembly and the rear wheel test assembly to adjust the position and rotation speed of the front wheel test assembly and the rear wheel test assembly, and is configured to be able to synchronize the rotation speed of the front wheel test assembly and the rear wheel test assembly; it is characterized in that the front wheel test assembly comprises: a front base frame, which is fixed on the ground; two universal slides, which are slidably arranged on the front base frame along a second direction and are configured to be able to rotate around a vertical direction, wherein the second direction is perpendicular to the first direction and the vertical direction; a front wheel hub bracket, which is rotatably arranged on the universal slide; a slewing power-assist driving device, which is fixed to the front wheel hub bracket and is configured to drive the front wheel hub bracket to rotate around a vertical direction to cooperate with the steering of the front wheels of the vehicle.

According to an optional embodiment, the front wheel test assembly also includes: a front wheel hub, which is rotatably arranged on the front wheel hub bracket and whose rotation axis is parallel to the ground to cooperate with the rolling of the front wheel of the vehicle; and a front wheel hub motor, which is arranged on the front wheel hub bracket and connected to the front wheel hub by means of a front wheel hub transmission device to drive the front wheel hub.

According to an optional embodiment, the distance between the two universal slides corresponds to the front track of the vehicle.

According to an optional embodiment, the rear wheel test assembly includes: a rear base frame, which is fixed on the ground; a rear slide, which is slidably arranged on the rear base frame along a first direction; a rear wheel hub bracket, which is arranged on the rear slide; a rear slide drive device, which is fixed on the rear wheel hub bracket to drive the rear slide to translate along the first direction, and adjust the position of the rear slide on the rear base frame to adapt to the wheelbase of the vehicle; a rear wheel hub, which is rotatably arranged on the rear wheel hub bracket, and its rotation axis is parallel to the ground to cooperate with the rolling of the rear wheels of the vehicle; and a rear wheel hub motor, which is arranged on the rear wheel hub bracket and is connected to the rear wheel hub by means of a rear wheel hub transmission device to drive the rear wheel hub.

According to an optional embodiment, two front wheel hubs are arranged on each of the front wheel hub brackets; the front wheel hub transmission device is configured to connect the two front wheel hubs to the front wheel hub motor and enable the two front wheel hubs to rotate synchronously; two of the rear wheel hubs are arranged on each of the rear wheel hub brackets; the rear wheel hub transmission device is configured to connect the two rear wheel hubs to the rear wheel hub motor and enable the two rear wheel hubs to rotate synchronously.

According to an optional embodiment, two front wheel hubs are arranged on each of the front wheel hub brackets; the front wheel hub transmission device is configured to connect the two front wheel hubs with the front wheel hub motor and enable the two front wheel hubs to rotate synchronously; one rear wheel hub is arranged on each of the rear wheel hub brackets; the rear wheel hub transmission device is configured to connect the rear wheel hub with the rear wheel hub motor.

According to an optional embodiment, a front wheel hub is arranged on each of the front wheel hub brackets; the front wheel hub transmission device is configured to connect the front wheel hub with the front wheel hub motor; and a rear wheel hub is arranged on each of the rear wheel hub brackets; the rear wheel hub transmission device is configured to connect the rear wheel hub with the rear wheel hub motor.

According to an optional embodiment, the rotation of the front wheel test assembly around the vertical direction is achieved by a passive method, an active method or a fusion method; in the passive method, the steering system of the vehicle provides steering power to drive the front wheels of the vehicle to steer, and then the front wheels of the vehicle drive the front wheel hub that is in rolling contact with the front wheels to steer; in the active method, the steering power is provided by the slewing power-assist driving device of the front wheel test assembly to drive the front wheel hub bracket and the front wheel hub disposed thereon to rotate around the vertical direction, and then the front wheels of the vehicle that are in rolling contact with the front wheel hub and the steering mechanism are driven to steer synchronously; and in the fusion method, the control device receives a steering command signal from the steering control system of the vehicle to control the slewing power-assist driving device to follow the steering command signal to provide auxiliary power, driving the front wheel hub bracket and the front wheel hub disposed thereon to steer synchronously with the front wheels of the vehicle.

The present application also proposes a vehicle test bench, comprising: a chassis dynamometer according to the present application, which is arranged in a pit in the room where the vehicle test bench is located and is basically flush with the indoor ground surface; a display device, which is arranged around the chassis dynamometer and is configured to display images to simulate the road environment and scene of vehicle driving; an airflow simulation device, which is arranged near the chassis dynamometer and is configured to generate airflow to simulate ambient wind; and a temperature control device, which is arranged indoors and away from the chassis dynamometer, and is used to control the indoor temperature to simulate the ambient temperature.

The present application also proposes a method for simulating actual road driving of a vehicle, characterized in that the method comprises the following steps: step S101: parking the vehicle on the chassis dynamometer according to the present application; step S102: adjusting the positions of the front wheel test assembly and the rear wheel test assembly by means of the control device of the chassis dynamometer, so that the front wheel and the rear wheel of the vehicle are respectively in contact with the front wheel hub and the rear wheel hub, wherein in the case where two front wheel hubs are provided on each front wheel hub bracket, the front wheel of the vehicle is embedded between the two front wheel hubs, and the rear wheel of the vehicle is tangent to the rear wheel hub, and in the case where one front wheel hub 1004 is provided on each front wheel hub bracket, the front wheel of the vehicle is tangent to the front wheel hub, and the rear wheel of the vehicle is tangent to the rear wheel hub; step S103: fixing the vehicle on the chassis dynamometer by means of a fixing device, so that the vehicle does not move relative to the chassis dynamometer during the test ; and step S104: starting the tested vehicle by the driver or the automatic driving controller, and performing operations such as acceleration, deceleration and steering to simulate road driving.

According to an optional embodiment, in step S104, when the vehicle is a front-wheel drive vehicle, the movement of the front wheels of the vehicle is transmitted to the front wheel hub transmission device with the aid of the front wheel hub to be transmitted to the front wheel hub motor, and the speed of the rear wheel hub motor is set according to the speed of the front wheel hub motor with the aid of the control device to drive the rear wheels to rotate through the rear wheel hub transmission device and the rear wheel hub; when the tested vehicle is a rear-wheel drive vehicle, the movement of the rear wheels of the vehicle is transmitted to the rear wheel hub transmission device with the aid of the rear wheel hub to be transmitted to the rear wheel hub motor, and the speed of the front wheel hub motor is set according to the speed of the rear wheel hub motor with the aid of the control device to drive the front wheels to rotate through the front wheel hub transmission device and the front wheel hub.

The chassis dynamometer and vehicle test bench according to the present application can meet the simulation of any steering angle of the tested vehicle within its maximum speed and maximum steering angle range, and can achieve synchronization of the front and rear wheels of the tested vehicle. The chassis dynamometer and vehicle test bench according to the present application can solve the technical problems of high risk and limited environmental impact of road tests in the prior art, can simulate the steering and front and rear wheel synchronization of the vehicle while driving, replace some road test functions, save a lot of manpower and material resources, save huge costs, and have the advantages of simple structure, easy operation, safety and efficiency.

### BRIEF DESCRIPTION OF THE DRAWINGS

The above and other aspects of the present application will be more fully understood from the detailed description below in conjunction with the following drawings. It should be noted that the scales of the drawings may be different for the purpose of clear description, but this will not affect the understanding of the present application.
FIG. 1 shows a side view of a vehicle test bench according to the present application.
FIG. 2 shows a top view of the vehicle test bench of FIG. 1 .
FIG. 3 is a perspective view showing a front wheel test assembly of the chassis dynamometer of the vehicle test bench of FIG. 1 .
FIG. 4 shows a perspective view of the front wheel test assembly of FIG. 3, wherein the front wheel test assembly is in a steering position.
FIG. 5 shows a side view of another embodiment of a front wheel test assembly.
FIG. 6 shows a flow chart of a method for simulating steering and synchronizing the front wheels with the rear wheels while the vehicle is moving.

### DETAILED DESCRIPTION

The exemplary embodiments of the present application will be described in more detail below with reference to the accompanying drawings. Although the exemplary embodiments of the present application are shown in the accompanying drawings, it should be understood that the present application can be implemented in various forms and should not be limited by the embodiments described here. On the contrary, these embodiments are provided in order to enable a more thorough understanding of the present application and to fully convey the scope of the present application to those skilled in the art. It should be noted that when an element is referred to as "fixed to" or "set to" another element, it can be directly on another element or indirectly on the other element. When an element is referred to as "connected to" another element, it can be directly connected to another element or indirectly connected to the other element. It should be understood that the orientation or positional relationship indicated by the terms "length", "width", "upper", "lower", "front", "back", "left", "right", "vertical", "horizontal", "top", "bottom", "inside", "outside", etc. is based on the orientation or positional relationship shown in the accompanying drawings, which is only for the convenience of describing the present application and simplifying the description, rather than indicating or implying that the device or element referred to must have a specific orientation, be constructed and operated in a specific orientation, and therefore cannot be understood as a limitation to the present application. In addition, the terms "first" and "second" are used for descriptive purposes only and should not be understood as indicating or implying relative importance or implicitly indicating the number of technical features indicated. Therefore, a feature defined as "first" or "second" may explicitly or implicitly include one or more of the features. In the description of this application, "multiple" and "several" mean two or more, unless otherwise clearly and specifically defined.

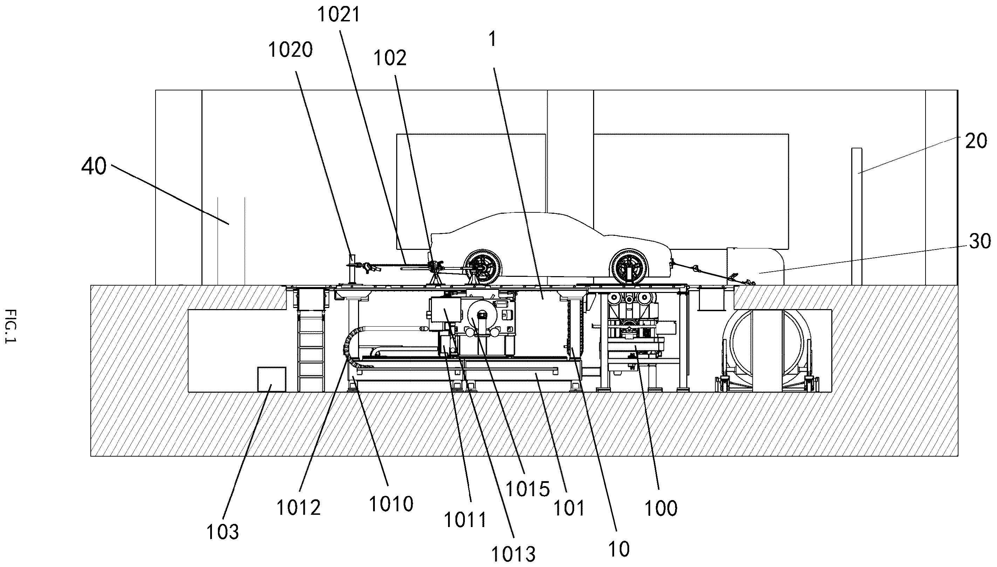

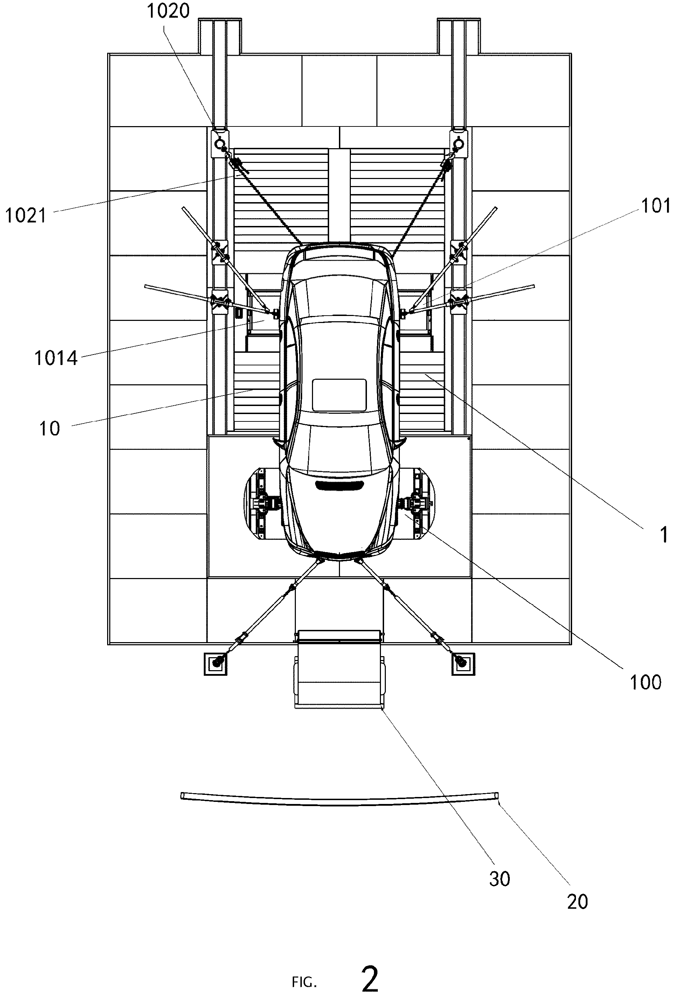

FIG. 1 shows a side view of a vehicle test bench according to the present application. FIG. 2 shows a top view of the vehicle test bench of FIG. 1 . The vehicle test bench according to the present application is a rolling test bench in which the vehicle can be kept in the middle of the vehicle test bench fully automatically. During the test, the control methods of the vehicle on the vehicle test bench include: control by the driver in the vehicle, control by the automatic driving controller in the vehicle, and joint control by the automatic driving controller and the auxiliary controller of the vehicle test bench. **In** addition to rolling tests, braking tests, and ABS tests, the vehicle test bench according to the present application can also perform tests with steering operations and dynamic functional tests of automatic driving vehicles, such as automatic driving behavior tests under typical traffic conditions.

As shown in FIG. 1, the vehicle test bench 1 includes a chassis dynamometer 10, a display device 20, an airflow simulation device 30 and a temperature control device 40. The vehicle test bench 1 is arranged in a relatively closed room. The chassis dynamometer 10 is arranged in a pit in the room and is substantially flush with the indoor ground surface. The display device 20 is arranged around the chassis dynamometer 10, and is used to display images to simulate the environment. The airflow simulation device 30 is arranged near the chassis dynamometer 10, and is used to generate airflow to simulate the ambient wind. The temperature control device 40 is arranged indoors and away from the chassis dynamometer 10, and is used to control the indoor temperature to simulate the ambient temperature.

For the convenience of subsequent description, the first coordinate system of the vehicle test bench 1 is defined here. In the first coordinate system, the X-axis direction is the straight-line driving direction of the vehicle in the vehicle test bench 1; the Z-axis direction is the vertical direction; and the Y-axis direction is the horizontal direction orthogonal to the X-axis and the Z-axis.

The chassis dynamometer 10 includes a front wheel test assembly 100, a rear wheel test assembly 101, a fixing device 102, and a control device 103. The rear wheel test assembly 101 is separated from the front wheel test assembly 100 by a distance along the X-axis direction, and the distance between the rear wheel test assembly 101 and the front wheel test assembly 100 can be adjusted to adapt to different vehicle wheelbases. The fixing device 102 is arranged near the front wheel test assembly 100 and the rear wheel test assembly 101, and is connected to the body and wheels of the vehicle under test, and is used to fix the vehicle under test on the chassis dynamometer 10. The control device 103 is electrically connected to the front wheel test assembly 100 and the rear wheel test assembly 101 to adjust the position and rotation speed of the front wheel test assembly 100 and the rear wheel test assembly 101, and can synchronize the rotation speeds of multiple front wheel test assemblies 100 and multiple rear wheel test assemblies 101.

The rear wheel test assembly 101 includes a rear chassis 1010, a rear slide 1011, a rear wheel hub bracket 1012, a rear slide drive 1013, a rear wheel hub 1014 (not shown in FIG. 1, see FIG. 2), a rear wheel hub motor 1015 and a rear wheel hub transmission device. The rear chassis 1010 is fixed to the bottom of the indoor pit. The rear slide 1011 is slidably arranged on the rear chassis 1010 along the X-axis direction. The rear wheel hub bracket 1012 is arranged on the rear slide 1011. The rear slide drive 1013 is fixed on the rear wheel hub bracket 1012, and is used to drive the rear slide 1011 to translate along the X-axis to adjust the position of the rear slide 1011 on the rear chassis 1010 to adapt to the wheelbase of the tested vehicle. The rear wheel hub 1014 is rotatably disposed on the rear wheel hub bracket 1012, and its rotation axis is parallel to the ground to cooperate with the rolling of the rear wheel of the vehicle under test, that is, the rear wheel hub 1014 can roll on the rear wheel hub bracket 1012. The rear wheel hub motor 1015 is disposed on the rear wheel hub bracket 1012 and is connected to the rear wheel hub 1014 by means of a rear wheel hub transmission device, for driving the rear wheel hub 1014.

Although in the embodiment of FIG. 1, only one rear wheel hub 1014 is disposed on the rear wheel hub bracket 1012, it is understandable that the present application also includes the case where two rear wheel hubs 1014 are disposed on the rear wheel hub bracket 1012. In this case, the rear wheel hub transmission device is configured to connect the two rear wheel hubs 1014 to the rear wheel hub motor 1015 and to make the two rear wheel hubs 1014 rotate synchronously.

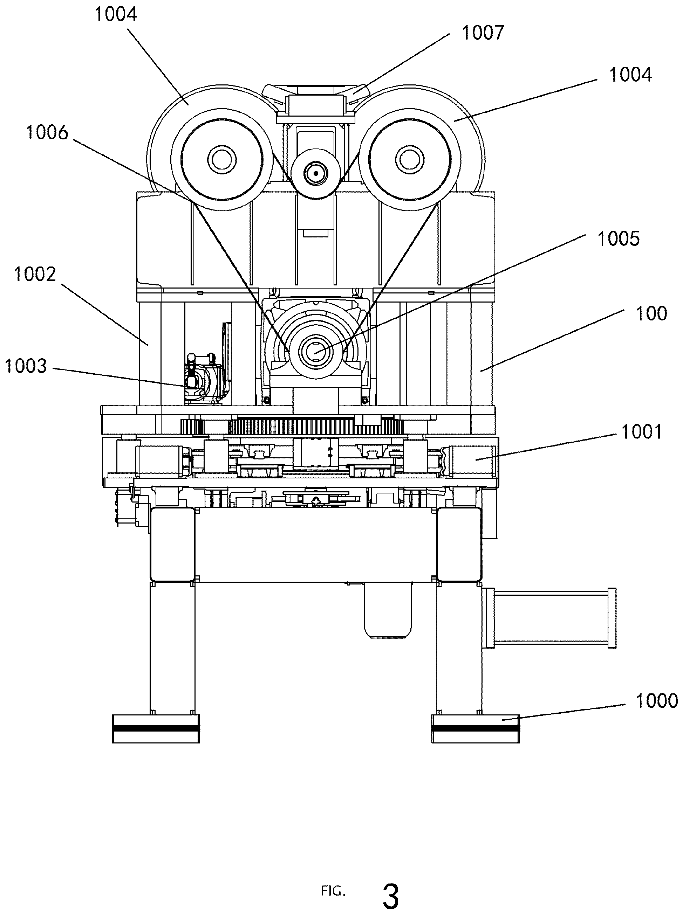

FIG. 3 shows a side view of the front wheel test assembly of the chassis dynamometer of the vehicle test bench of FIG. 1 . The front wheel test assembly 100 includes a front base frame 1000, two universal slides 1001 (one of which is shown in the figure), a front wheel hub bracket 1002, a slewing power-assist driving device 1003, a front wheel hub 1004, a front wheel hub motor 1005 and a front wheel hub transmission device 1006. The front base frame 1000 is fixed to the bottom of an indoor pit. The universal slide 1001 is slidably arranged on the front base frame 1000 along the Y-axis direction and can rotate around the Z-axis. The spacing between the two universal slides 1001 depends on the front wheel track of the vehicle under test. The front wheel hub bracket 1002 is rotatably arranged on the universal slide 1001. The slewing power-assist driving device 1003 is fixed on the front wheel hub bracket 1002 and is used to drive the front wheel hub bracket 1002 to rotate around the Z-axis direction. The slewing power-assist driving device 1003 may be a motor, on which a small gear is fixed, and the large gear fixed on the front wheel hub bracket 1002 is driven to rotate by gear transmission, so as to drive the front wheel hub bracket 1002 to rotate. The front wheel hub 1004 is rotatably arranged on the front wheel hub bracket 1002, and its rotation axis is parallel to the ground to cooperate with the rolling of the front wheels of the tested vehicle, that is, the front wheel hub 1004 can roll on the front wheel hub bracket 1002. The front wheel hub motor 1005 is arranged on the front wheel hub bracket 1002 and is connected to the front wheel hub 1004 by means of the front wheel hub transmission device 1006, and is used to drive the front wheel hub 1004.

As shown in Fig. 2 and Fig. 3, in this embodiment, two front wheel hubs 1004 are arranged on each front wheel hub bracket 1002. The front wheel hub transmission device 1006 connects the two front wheel hubs 1004 with the front wheel hub motor 1005 and makes the two front wheel hubs 1004 rotate synchronously. The technical effect of arranging two front wheel hubs 1004 on each front wheel hub bracket 1002 is that the front wheel of the tested vehicle can be positioned between the two front wheel hubs 1004 on each front wheel hub bracket 1002, so that it is more stable when rotating. The front wheel test assembly 100 also includes a safety blocking roller 1007 arranged between the two front wheel hubs 1004 to prevent the front wheel of the tested vehicle from slipping out from between the two front wheel hubs 1004.

It should be noted that, when one rear wheel hub 1014 is provided on the rear wheel hub bracket 1012, one or two front wheel hubs 1004 may be provided on each front wheel hub bracket 1002; when two rear wheel hubs 1014 are provided on the rear wheel hub bracket 1012, only two front wheel hubs 1004 may be provided on each front wheel hub bracket 1002.

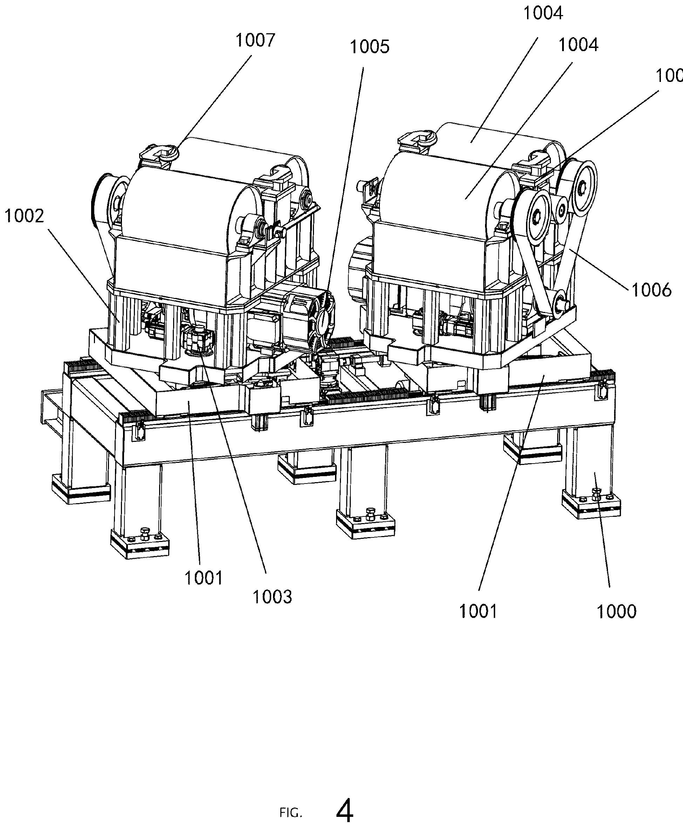

FIG. 4 shows a stereoscopic view of the front wheel test assembly of FIG. 3, wherein the front wheel test assembly is in a steering position. The front wheel test assembly 100 is rotated from the default (straight ahead) position to the steering position in three ways. The first way is that the steering system of the tested vehicle drives the front wheels of the tested vehicle to steer, and then the front wheels drive the front wheel hub 1004 that is in rolling contact with the front wheels to steer. In this case, the steering system of the tested vehicle provides the steering power. The second way is that the slewing power-assisted drive device 1003 of the front wheel test assembly 100 provides the steering power to drive the front wheel hub bracket 1002 and the front wheel hub 1004 disposed thereon to rotate around the Z-axis direction, and then drive the front wheel that is in rolling contact with the front wheel hub 1004 and the steering mechanism to steer synchronously. The third method is that the steering control system of the tested vehicle outputs a steering command signal to the control device 103, and then the control device 103 controls the slewing power driving device 1003 of the front wheel test assembly 100 to follow the steering command signal to provide auxiliary power, so as to realize the synchronous steering of the front wheel hub bracket 1002 and the front wheel hub 1004 arranged thereon and the front wheel.

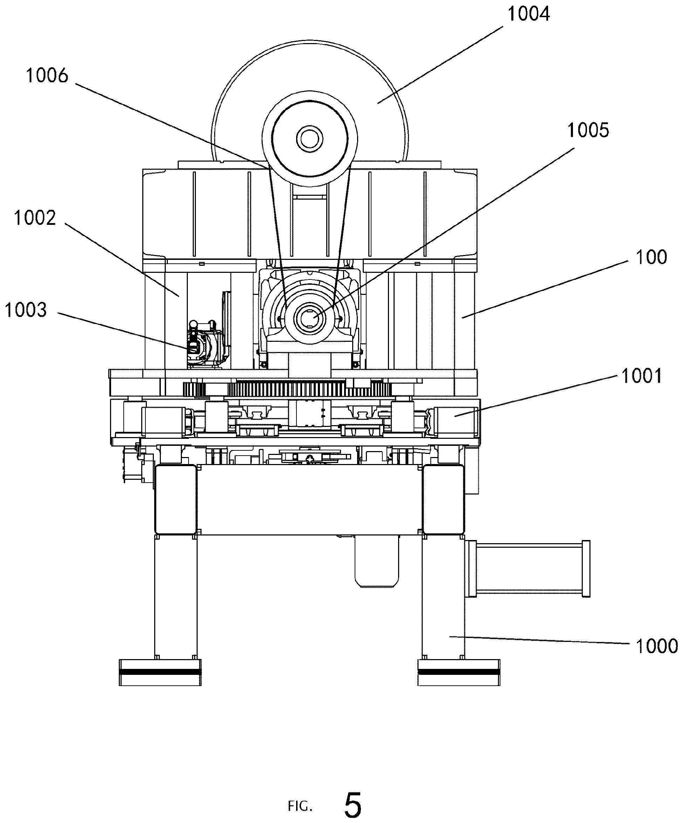

FIG. 5 shows a side view of another embodiment of the front wheel test assembly. Compared with the embodiment of FIG. 2, in the embodiment of FIG. 5, a front wheel hub 1004 is provided on each front wheel hub bracket 1002. A front wheel hub transmission device 1006 connects the front wheel hub 1004 to the front wheel hub motor 1005. The technical effect of providing a front wheel hub 1004 on each front wheel hub bracket 1002 is that there is no need for a complex front wheel hub transmission device 1006 to synchronize the rotation speeds of different front wheel hubs 1004 on the same front wheel hub bracket 1002, thereby simplifying the overall structure of the front wheel test assembly 100. In this embodiment, the front wheel test assembly 100 does not include a safety blocking roller 1007.

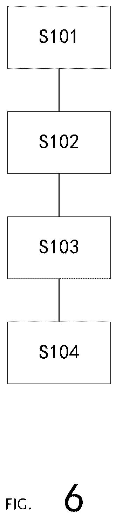

FIG. 6 shows a flow chart of a method for simulating steering and synchronizing the front and rear wheels during vehicle driving. The method comprises the following steps:
Step S101 : Stop the vehicle under test on the chassis dynamometer 10 .
Step S102: adjusting the positions of the front wheel test assembly 100 and the rear wheel test assembly 101 by means of the control device 103 of the chassis dynamometer 10 so that the front wheels and rear wheels of the tested vehicle abut against the front wheel hub 1004 and the rear wheel hub 1014 respectively.

In the case where two front wheel hubs 1004 are disposed on each front wheel hub bracket 1002, in step S102, the front wheel of the tested vehicle is embedded between the two front wheel hubs 1004, and the rear wheel of the tested vehicle is tangent to the rear wheel hub 1014 .

In the case where a front wheel hub 1004 is disposed on each front wheel hub bracket 1002, in step S102, the front wheel of the tested vehicle is tangent to the front wheel hub 1004, and the rear wheel of the tested vehicle is tangent to the rear wheel hub 1014 .

Step S103: Fix the vehicle under test on the chassis dynamometer 10 by means of the fixing device 102 so that the vehicle under test does not move relative to the chassis dynamometer 10 during the test .

Step S104: The driver or the automatic driving controller starts the vehicle under test and performs operations such as acceleration, deceleration and steering to simulate road driving.

Due to the presence of the steering trapezoid, the wheel will slide along the Y-axis direction (i.e., transverse to the vehicle's forward direction) when turning, and this sliding can be compensated by the sliding of the universal slide 1001 along the Y-axis direction. In the case where the tested vehicle is front-wheel drive, the movement of the front wheel of the tested vehicle is transmitted to the front wheel hub transmission device 1006 through the front wheel hub 1004, and then transmitted to the front wheel hub motor 1005. The control device 103 sets the speed of the rear wheel hub motor 1015 according to the speed of the front wheel hub motor 1005, thereby driving the rear wheel to rotate through the rear wheel hub transmission device and the rear wheel hub 1014. In the case where the tested vehicle is rear-wheel drive, the above-mentioned power transmission process is opposite. The movement of the rear wheel of the tested vehicle is transmitted to the rear wheel hub transmission device through the rear wheel hub 1014, and then transmitted to the rear wheel hub motor 1015. The control device 103 sets the rotation speed of the front wheel hub motor 1005 according to the rotation speed of the rear wheel hub motor 1015, thereby driving the front wheel to rotate through the front wheel hub transmission device 1006 and the front wheel hub 1004. In this way, the steering operation of the tested vehicle during driving on the simulated road and the rotation speed synchronization of the front and rear wheels can be achieved.

In one embodiment, the fixing device 102 includes a tension pile 1020 and a flexible chain 1021. The tension pile 1020 is fixed on the ground. The flexible chain 1021 is connected between the tension pile 1020 and the front wheel or the rear wheel of the vehicle under test to make the test process more stable.

The maximum speed of the vehicle under test in the steering state on the vehicle test bench 1 is usually set lower than the maximum speed in the non-steering (i.e., straight) state to improve the safety of the test. The maximum speed and torque of the vehicle under test can be adjusted according to the specifications of the front wheel hub motor 1005 and the rear wheel hub motor 1015. During the test, the tester (or the automatic driving control device) turns the steering wheel of the vehicle under test within the maximum speed and maximum steering angle range.

The vehicle test bench 1 according to the present application can meet the simulation of any steering angle of the tested vehicle within its maximum speed and maximum steering angle range, and can achieve synchronization of the front and rear wheels of the tested vehicle. The vehicle test bench 1 according to the present application can solve the technical problems of high risk and limited environmental impact of road tests in the prior art, and can achieve the function of simulating steering and synchronization of front and rear wheels during vehicle driving, replacing some road test functions, which will save a lot of manpower and material resources, save huge costs, and have the advantages of simple structure, easy operation, safety and high efficiency.

The control device 103 includes a non-volatile memory, a data processing unit and a read/write memory. The non-volatile memory has a memory element in which a computer program P is stored. When the computer program is executed, the data processing unit executes the method for simulating steering and synchronizing the front and rear wheels in vehicle driving according to the present application. The control device 103 further includes a bus controller, a serial communication port, an I/O component, an A/D converter, a time and date input and transmission unit, an event counter, an interrupt controller, etc. ( not shown ).

Where a data processing unit is described as performing a specific function, this means that the data processing unit affects a specific part of a program stored in the non-volatile memory or a specific part of a program stored in the read/write memory.

It is understood by those skilled in the art that, in addition to implementing the method for simulating steering and synchronizing the front and rear wheels during vehicle driving in a purely computer-readable program code, the steps of the method can also be logically programmed to enable the control device 103 to implement the same function in the form of logic gates, switches, application-specific integrated circuits, programmable logic controllers, and embedded microcontrollers. Therefore, the control device 103 can be considered as a hardware component, and the devices included therein for implementing various functions can also be considered as structures within the hardware component. Alternatively, the devices for implementing various functions can be considered as both software modules for implementing the method and structures within the hardware component.

The foregoing description of the embodiments has been provided for illustrative and descriptive purposes. It is not intended to be exhaustive or to limit the embodiments to the described variants. Many modifications and variations will be apparent to those skilled in the art. The embodiments are selected and described in order to best illustrate the principles and practical applications, so that those skilled in the art can understand the embodiments in their various embodiments and various modifications suitable for their intended use. Within the framework of the embodiments, the above-mentioned components and features can be combined between different embodiments.

## Claims

1. A chassis dynamometer (10) for testing a vehicle, the chassis dynamometer comprising :
front wheel test assembly (100);
a rear wheel test assembly (101) which is spaced apart from the front wheel test assembly (100) by a distance along a first direction and is configured to be able to adjust the distance between the rear wheel test assembly (101) and the front wheel test assembly (100) to adapt to different vehicle wheelbases;
a control device (103) electrically connected to the front wheel test assembly (100) and the rear wheel test assembly (101) to adjust the position and rotation speed of the front wheel test assembly (100) and the rear wheel test assembly (101), and configured to synchronize the rotation speed of the front wheel test assembly (100) and the rear wheel test assembly (101);
**characterized in that** the front wheel testing assembly (100) comprises:
a front base frame (1000) fixed to the ground;
two universal slides (1001) are slidably arranged on the front base frame (1000) along a second direction and are configured to be rotatable around a vertical direction, wherein the second direction is perpendicular to the first direction and the vertical direction;
a front wheel hub bracket (1002) rotatably arranged on the universal slide (1001);
a slewing power-assist driving device (1003) is fixed on the front wheel hub bracket (1002) and is configured to drive the front wheel hub bracket (1002) to rotate around a vertical direction to cooperate with the steering of the front wheels of the vehicle.

2. The chassis dynamometer (10) according to claim 1, **characterized in that** the front wheel test assembly (100) further comprises:
a front wheel hub (1004) rotatably disposed on the front wheel hub bracket (1002) and having a rotation axis parallel to the ground for rolling cooperation with the front wheel of the vehicle; and
a front wheel hub motor (1005) is arranged on the front wheel hub bracket (1002) and is connected to the front wheel hub (1004) by means of a front wheel hub transmission device (1006) to drive the front wheel hub (1004).

3. The chassis dynamometer (10) according to claim 2, **characterized in that** the distance between the two universal slides (1001) corresponds to the front wheel track of the vehicle.

4. The chassis dynamometer (10) according to any one of claims 1 to 3, **characterized in that** the rear wheel test assembly (101) comprises:
a rear chassis (1010) fixed to the ground;
a rear slide (1011) slidably arranged on the rear chassis (1010) along a first direction;
a rear wheel hub bracket (1012), which is arranged on the rear slide platform (1011);
a rear slide drive device (1013) fixed on the rear wheel hub bracket (1012) to drive the rear slide (1011) to translate along a first direction, and to adjust the position of the rear slide (1011) on the rear chassis (1010) to adapt to the wheelbase of the vehicle;
a rear wheel hub (1014) rotatably disposed on the rear wheel hub bracket (1012) and having a rotation axis parallel to the ground so as to roll with the rear wheel of the vehicle; and
a rear wheel hub motor (1015) is arranged on the rear wheel hub bracket (1012) and is connected to the rear wheel hub (1014) by means of a rear wheel hub transmission device to drive the rear wheel hub (1014).

5. The chassis dynamometer (10) according to claim 4, **characterized in that**:
two front wheel hubs (1004) are arranged on each front wheel hub bracket (1002);
the front wheel hub transmission device (1006) is configured to connect the two front wheel hubs (1004) to the front wheel hub motor (1005) and enable the two front wheel hubs (1004) to rotate synchronously;
two rear wheel hubs (1014) are arranged on each rear wheel hub bracket (1012);
the rear wheel hub transmission device is configured to connect the two rear wheel hubs (1014) to the rear wheel hub motor (1015) and enable the two rear wheel hubs (1014) to rotate synchronously.

6. The chassis dynamometer (10) according to claim 4, **characterized in that**:
two front wheel hubs (1004) are arranged on each front wheel hub bracket (1002);
the front wheel hub transmission device (1006) is configured to connect the two front wheel hubs (1004) to the front wheel hub motor (1005) and enable the two front wheel hubs (1004) to rotate synchronously;
a rear wheel hub (1014) is disposed on each rear wheel hub bracket (1012);
the rear wheel hub transmission is configured to connect the rear wheel hub (1014) to the rear wheel hub motor (1015).

7. The chassis dynamometer (10) according to claim 4, **characterized in that**:
a front wheel hub (1004) is disposed on each front wheel hub bracket (1002);
the front wheel hub transmission device (1006) is configured to connect the front wheel hub (1004) with the front wheel hub motor (1005);
each of the rear wheel hub brackets (1012) is provided with a rear wheel hub (1014);
the rear wheel hub transmission is configured to connect the rear wheel hub (1014) to the rear wheel hub motor (1015).

8. The chassis dynamometer (10) according to claim 2 or 3, **characterized in that**:
the rotation of the front wheel test assembly (100) around the vertical direction is achieved by a passive method, an active method or a fusion method;
in the passive mode, the steering system of the vehicle provides steering power to drive the front wheels of the vehicle to steer, and then the front wheels of the vehicle drive the front wheel hub (1004) in rolling contact with the front wheels to steer;
in the active mode, the slewing power-assist driving device (1003) of the front wheel test assembly (100) provides steering power to drive the front wheel hub bracket (1002) and the front wheel hub (1004) disposed thereon to rotate around a vertical direction, thereby driving the front wheel of the vehicle and the steering mechanism in rolling contact with the front wheel hub (1004) to steer synchronously; and
in the combined mode, the control device (103) receives a steering command signal from a steering control system of the vehicle to control the slewing power-assisting drive device (1003) to follow the steering command signal to provide auxiliary power, thereby driving the front wheel hub bracket (1002) and the front wheel hub (1004) disposed thereon to steer synchronously with the front wheels of the vehicle.

9. A vehicle test bench (1), comprising:
the chassis dynamometer (10) according to any one of claims 1 to 8, which is arranged in a pit in the room where the vehicle test bench (1) is located and is substantially flush with the floor surface of the room;
a display device (20) disposed around the chassis dynamometer (10) and configured to display images to simulate a road environment and scene on which a vehicle is traveling;
an airflow simulation device (30) disposed near the chassis dynamometer (10) and configured to generate an airflow to simulate ambient wind; and
a temperature control device (40) is arranged indoors and away from the chassis dynamometer (10), and is used to control the indoor temperature to simulate the ambient temperature.

10. A method for simulating actual road driving of a vehicle, **characterized in that** the method comprises the following steps:
step S101: Parking a vehicle on a chassis dynamometer (10) according to any one of claims 1 to 8;
step S102: adjusting the positions of the front wheel test assembly (100) and the rear wheel test assembly (101) by means of the control device (103) of the chassis dynamometer (10) so that the front wheel and the rear wheel of the vehicle are respectively in contact with the front wheel hub (1004) and the rear wheel hub (1014), wherein when two front wheel hubs (1004) are provided on each front wheel hub bracket (1002), the front wheel of the vehicle is embedded between the two front wheel hubs (1004), and the rear wheel of the vehicle is tangent to the rear wheel hub (1014); and when one front wheel hub 1004 is provided on each front wheel hub bracket (1002), the front wheel of the vehicle is tangent to the front wheel hub (1004), and the rear wheel of the vehicle is tangent to the rear wheel hub (1014);
step S103: fixing the vehicle on the chassis dynamometer (10) by means of the fixing device (102) so that the vehicle does not move relative to the chassis dynamometer (10) during the test; and
step S104: The driver or the automatic driving controller starts the vehicle under test and performs operations such as acceleration, deceleration and steering to simulate road driving.

11. The method according to claim 10, **characterized in that** in step S104,
when the vehicle is a front-wheel drive vehicle, the movement of the front wheel of the vehicle is transmitted to the front wheel hub transmission device (1006) by means of the front wheel hub (1004) to be transmitted to the front wheel hub motor (1005), and the speed of the rear wheel hub motor (1015) is set according to the speed of the front wheel hub motor (1005) by means of the control device (103) to drive the rear wheel to rotate through the rear wheel hub transmission device and the rear wheel hub (1014);
when the tested vehicle is rear-wheel drive, the movement of the rear wheel of the vehicle is transmitted to the rear wheel hub transmission device via the rear wheel hub (1014) to be transmitted to the rear wheel hub motor (1015), and the rotation speed of the front wheel hub motor (1005) is set according to the rotation speed of the rear wheel hub motor (1015) via the control device ( 103) to drive the front wheel to rotate through the front wheel hub transmission device (1006) and the front wheel hub (1004).
